Europäisches Patentamt

European Patent Office

Office européen des brevets

(19)

(11) **EP 0 866 958 B1**

(12) **FASCICULE DE BREVET EUROPEEN**

(45) Date de publication et mention
de la délivrance du brevet:
**13.03.2002   Bulletin 2002/11**

(51) Int Cl.⁷: **G01L 9/04**, G01D 3/036,
G01R 17/10

(21) Numéro de dépôt: **96941696.5**

(22) Date de dépôt: **04.12.1996**

(86) Numéro de dépôt international:
**PCT/FR96/01933**

(87) Numéro de publication internationale:
**WO 97/21083 (12.06.1997 Gazette 1997/25)**

(54) **PONT DE WHEATSTONE AVEC COMPENSATION DE GRADIENT DE TEMPERATURE**

WHEATSTONE-BRÜCKE MIT TEMPERATURGRADIENTENKOMPENSATION

WHEATSTONE BRIDGE WITH TEMPERATURE GRADIENT COMPENSATION

(84) Etats contractants désignés:
**CH DE ES FR GB LI**

(30) Priorité:  **04.12.1995  FR 9514295**

(43) Date de publication de la demande:
**30.09.1998   Bulletin 1998/40**

(73) Titulaire: **SOCIETE NATIONALE D'ETUDE ET DE
CONSTRUCTION DE MOTEURS D'AVIATION,
"S.N.E.C.M.A."
75015 Paris (FR)**

(72) Inventeurs:
• **AVISSE, Jean-Bernard
F-33480 Castelneau-de-Medoc (FR)**
• **CHIRON, Jeanine
F-33270 Floirac (FR)**

(74) Mandataire: **Joly, Jean-Jacques et al
Cabinet Beau de Loménie
158, rue de l'Université
75340 Paris Cédex 07 (FR)**

(56) Documents cités:
EP-A- 0 584 652        DE-U- 8 815 056
US-A- 4 565 097        US-A- 5 375 474

## Description

La présente invention concerne un circuit électrique de type "Pont de Wheatstone" et, en particulier, un tel circuit électrique dans lequel il y a une compensation automatique pour des différences de température existant entre les branches du pont.

Les circuits électriques de type "Pont de Wheatstone" sont bien connus. Ils sont utilisés dans des applications très diverses afin de produire une tension de sortie dont la variation montre l'existence d'un déséquilibre entre les résistances des branches du pont, et indique la grandeur de celui-ci. Normalement les circuits de ce genre sont conçus afin de détecter des déséquilibres dus à la variation d'un paramètre principal par rapport à une valeur de référence ou dus à des phénomènes affectant de manière différente les résistances des différentes branches du circuit. Evidemment, il est préférable que le comportement du circuit ne soit pas affecté par d'autres paramètres ou phénomènes tels, par exemple, la température environnante.

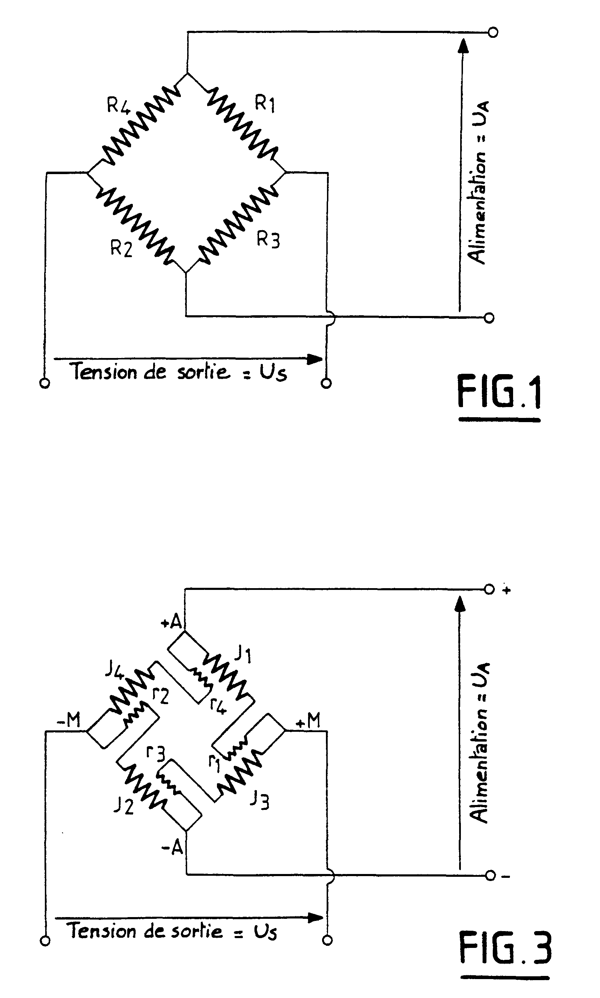

En théorie, dans le cas d'un pont de Wheatstone classique tel que représenté sur la figure 1, la tension de sortie, $U_S$, dépend des résistances $R_1$ à $R_4$ du pont, et de l'alimentation, $U_A$, selon l'équation (1) ci-dessous:

$$U_S = U_A \; \frac{R_1 R_2 - R_3 R_4}{(R_1 + R_3)(R_2 + R_4)} \qquad (1)$$

En pratique, les résistances des éléments $R_1$ à $R_4$ varient en fonction de la température ambiante et du coefficient de température des résistances (CTR), $\alpha$, quand ce dernier n'est pas nul. S'il y a un écart $\theta_i$ entre la température de chaque élément $R_i$ et une température de référence, l'équation théorique (1) est transformée en l'équation (2) ci-dessous:

$$U_S = U_A \; \frac{R_1(1+\alpha\theta_1)R_2(1+\alpha\theta_2) - R_3(1+\alpha\theta_3)R_4(1+\alpha\theta_4)}{(R_1(1+\alpha\theta_1)+R_3(1+\alpha\theta_3))(R_2(1+\alpha\theta_2)+R_4(1+\alpha\theta_4))} \qquad (2)$$

(Dans l'équation (2), et dans celles qui suivent, le coefficient de température des résistances, $\alpha$, est traité comme étant identique pour les quatre éléments du pont de Wheatstone. En pratique, il est relativement simple de choisir les éléments du pont pour que cette simplification soit approximativement valable).

Dans le cas où les quatre éléments $R_i$ du pont de Wheatstone sont tous à la même température, $\theta$, et la tension d'alimentation est fixe, en supposant que $\alpha\theta \ll 1$, l'équation (2) se simplifie et devient identique à l'équation (1). Ainsi, dans un tel cas la température ambiante n'affecte guère le comportement du pont de Wheatstone. (Il est possible, quand même, qu'il y ait un effet résiduel de température sur le pont du fait, par exemple, des déformations du support mécanique sur lequel les résistances sont déposées).

Dans le cas où les éléments $R_i$ du pont de Wheatstone ne sont pas tous à la même température, l'équation (2) garde quelques composants dont la valeur dépend de la température locale des éléments $R_i$. Cet effet nuit à la précision de la mesure effectuée en utilisation du circuit.

Le principe du pont de Wheatstone est utilisé, entre autres, dans le domaine des capteurs de pression à jauges extensométriques.

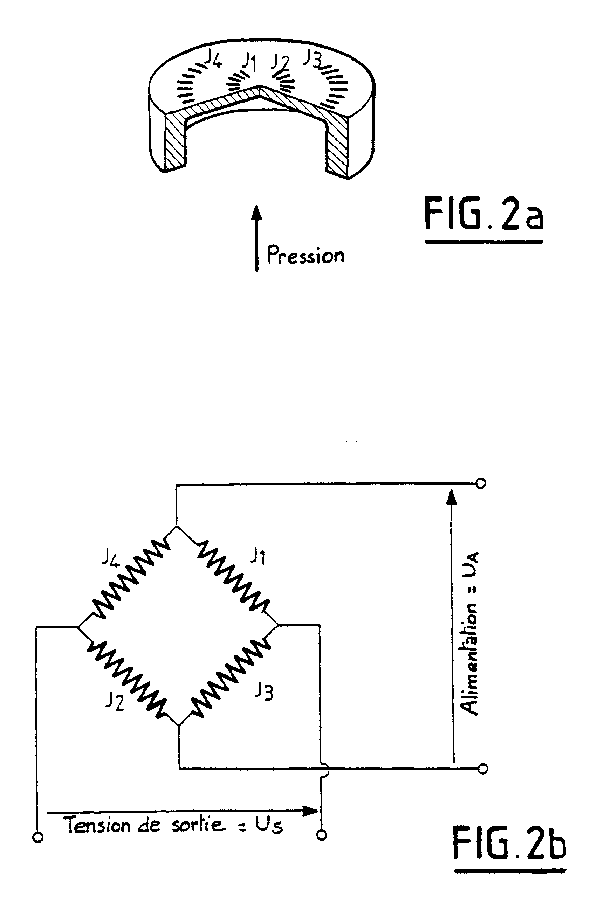

La construction typique d'un tel capteur de pression est représentée de façon schématique sur la figure 2, dont la figure 2(a) indique la disposition physique des jauges extensométriques dans le capteur et la figure 2(b) représente le circuit électrique correspondant. Dans le capteur de la figure 2(a), quatre jauges extensométriques, $J_1$ à $J_4$, sont disposés sur une membrane déformable, deux jauges $J_1$, $J_2$ se trouvant dans la région centrale de la membrane et les autres deux jauges $J_3$, $J_4$ se trouvant vers la périphérie de cette dernière. Les jauges extensométriques présentent chacune la même résistance électrique, R, à une température et une pression de référence. Des connexions électriques (non représentées) sont prévues entre les jauges $J_1$ à $J_4$ ainsi qu'une source d'alimentation et des bornes de sortie, afin de constituer un circuit en pont de Wheatstone tel qu'indiqué sur la figure 2(b).

Dans un tel capteur de pression, la membrane se déforme en se bombant sous l'effet d'une pression exercée dans le sens de la flèche de la figure 2(a). Les efforts de traction produits dans la partie centrale de la membrane amènent une augmentation, $+\Delta R$, de la résistance des jauges $J_1$ et $J_2$, tandis que les efforts de compression produits dans la périphérique de la membrane amènent une réduction, $-\Delta R$, de la résistance des jauges $J_3$, $J_4$. Si toutes les jauges sont à la même température, ces variations de résistance affectent la tension de sortie du circuit électrique en pont de Wheatstone selon l'équation (3) ci-dessous :

$$U_S = U_A \left(\frac{\Delta R}{R}\right) \qquad (3)$$

Cette relation très simple permettrait le calcul de la variation de résistance et, ainsi, de la pression appliquée à la membrane du capteur.

Pourtant, si un gradient de température existe entre les jauges $J_1$ à $J_4$ du capteur, c'est l'équation (4) ci-dessous, plus compliquée, qui s'applique:

$$U_S = U_A \frac{(R+\Delta R)(1+\alpha\theta_1)(R+\Delta R)(1+\alpha\theta_2) - (R-\Delta R)(1+\alpha\theta_3)(R-\Delta R)(1+\alpha\theta_4)}{((R+\Delta R)(1+\alpha\theta_1)+(R+\Delta R)(1+\alpha\theta_3))((R-\Delta R)(1+\alpha\theta_2)+(R-\Delta R)(1+\alpha\theta_4))} \qquad (4)$$

Évidemment, une relation si compliquée, et dépendant des températures des jauges individuelles, ne permet pas la mesure précise de pression par le capteur.

Le document DE-U-88 15 056 décrit un capteur de charge à jauges extensométriques dont les jauges constituent les résistances principales d'un circuit électrique de type "pont de Wheatstone". Dans chaque branche du pont de Wheatstone une résistance supplémentaire est connectée en série avec la résistance principale. Toutes les résistances principales et toutes les résistances supplémentaires possèdent le même coefficient de température de résistance et la même valeur ohmique de résistance.

Dans ce circuit connu, chaque résistance supplémentaire est disposée physiquement dans le voisinage d'une des résistances principales d'une autre branche du pont de sorte que les effets dus à l'existence d'un gradient de température entre les résistances principales du pont sont compensés par des effets produits dans les résistances supplémentaires. Ainsi, l'existence d'un tel gradient de température ne devrait pas affecter le signal de sortie du pont de Wheatstone. Cependant, la façon dont cette compensation est réalisée dans le pont de Wheatstone du document DE-U-88 15 056 conduit à une perte de sensibilité considérable du capteur concerné. Plus précisément, la sensibilité du capteur à des variations de résistance survenant dans le pont de Wheatstone est réduite par la moitié.

Au vu des problèmes exposés ci-dessus, la présente invention vise à rendre la tension de sortie d'un circuit électrique du type "pont de Wheatstone" constitué de résistances dont le CTR est non nul insensible aux différences de température existant entre ces résistances tout en limitant la perte de sensibilité du signal de sortie du pont aux variations de résistance survenant dans le circuit.

La présente invention vise aussi à fournir un capteur comportant un circuit électrique du type "pont de Wheatstone" dont les variations de résistance correspondent à des variations d'un paramètre à mesurer et étant constitué de résistances dont le CTR est non nul, rendu insensible aux différences de température existant entre ces résistances dans une manière qui permet de conserver la sensibilité du capteur.

Afin de pallier les inconvénients mentionnés ci-dessus la présente invention prévoit un circuit électrique du type "pont de Wheatstone" comportant quatre éléments de résistance principaux ayant chacune sensiblement la même valeur ohmique de résistance, R, et sensiblement la même valeur de coefficient de température de résistance, $\alpha$, un élément de résistance principal se trouvant dans chaque branche du pont de Wheatstone, dans lequel chaque branche du pont de Wheatstone comporte un élément de compensation en série avec l'élément de résistance principal correspondant, les éléments de compensation présentant chacune sensiblement la même valeur ohmique de résistance, r, et sensiblement le même coefficient de température de résistance, $\beta$, ces valeurs se rapportant à celles des éléments de résistance principaux sensiblement selon la formule:

$$R\alpha = r\beta$$

et chacun des éléments de résistance principal partage son environnement thermique avec un élément de compensation d'une des branches adjacentes du pont de Wheatstone, caractérisé en ce que r < R et, de préférence, $r/R \leq \frac{1}{2}$.

Dans les modes de réalisation préférés de la présente invention, les éléments de résistance principaux et les éléments de compensation sont en deux métaux différents.

Dans un circuit électrique du type "pont de Wheatstone" selon la présente invention, l'effet sur la tension de sortie des différences de température existantes entre les branches du pont est éliminé grâce aux résistances de compensation agencé chacune dans l'environnement thermique de la résistance principale d'une branche du pont mais connectée en série avec la résistance principale d'une branche adjacente du pont. En utilisant des éléments de compensation dont la valeur ohmique de résistance est inférieure à celle des éléments de résistance principaux, la perte de sensibilité du pont de Wheatstone du fait de l'introduction de ces éléments de compensation est diminuée.

Une réduction importante de la perte de sensibilité du pont de Wheatstone est obtenue si la valeur ohmique de résistance, r, des éléments de compensation est sélectionnée égale à la moitié de la valeur ohmique de résistance, R, des éléments de résistance principaux. Dans un tel cas la sensibilité du pont de Wheatstone est diminuée par 25% seulement. Cependant, il est préférable d'employer des éléments de compensation dont la valeur ohmique de résistance respecte la relation $r/R \leq 1/10$, afin de ramener la perte de sensibilité en dessous de 5% ce qui peut être considéré comme étant pratiquement nul.

Puisque la relation $R\alpha = r\beta$ doit être respectée dans les circuits selon la présente invention, l'utilisation d'éléments de compensation possédant une valeur ohmique de résistance, r, réduite implique le choix d'un matériau à coefficient de température de résistance, $\beta$, élevé pour la fabrication de ces éléments de compensation. Des éléments de compensation en Nickel ($\beta = 4 \times 10^{-3}/°C$) conviennent particulièrement à cet égard.

La présente invention prévoit, aussi, un capteur de pression à jauges extensométriques comportant un tel circuit électrique du type pont de Wheatstone incluant des éléments de compensation, les jauges extensométriques constituant des résistances principales du pont.

Un capteur de pression de ce genre est protégé contre l'effet sur la tension de sortie des différences de température existantes entre les jauges extensométriques et, grâce au fait que la valeur ohmique de résistance des éléments de compensation est faible par rapport à celle des jauges extensométriques, une bonne sensibilité du capteur est conservée.

D'autres caractéristiques et avantages de la présente invention seront mieux compris à la lecture de la description qui va suivre d'exemples de réalisation, faite en référence aux dessins annexés sur lesquels:

la figure 1 est un schéma représentant la structure classique d'un circuit électrique du type pont de Wheatstone;
la figure 2 représente la construction d'un capteur de pression à jauges extensométriques, dans laquelle:

la figure 2(a) indique la disposition physique des jauges extensométriques sur une membrane simple, et
la figure 2(b) représente le circuit électrique dont font partie ces jauges;

la figure 3 est un schéma de circuit représentant un circuit électrique de type pont de Wheatstone selon un mode de réalisation préféré de la présente invention;
la figure 4 est une vue en plan montrant la disposition physique des jauges extensométriques et des résistances de compensation dans un exemple d'un capteur de pression selon la présente invention, fabriqué par dépôt de couches minces sur une membrane;
la figure 5 est un graphique indiquant comment le signal de sortie du capteur de la figure 4 évolue en cas de choc thermique;
la figure 6 est un vue en plan montrant à titre comparatif un capteur semblable à celui de la figure 4 mais dépourvu de résistances de compensation; et
la figure 7 est un graphique indiquant à titre comparatif comment le signal de sortie du capteur de la figure 6 évolue en cas de choc thermique.

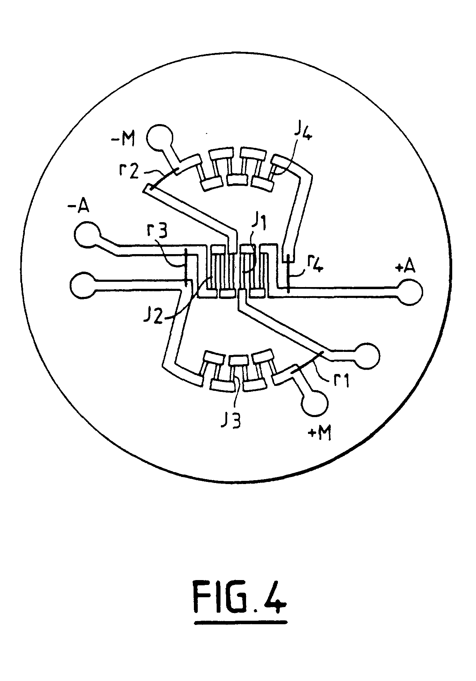

Le principe de la présente invention sera maintenant décrit dans le contexte d'un circuit du type pont de Wheatstone constitué des jauges extensométriques d'un capteur de pression, en se rapportant à la figure 3.

La figure 3 est un schéma de circuit représentant un circuit électrique du type pont de Wheatstone formé des quatre jauges extensométriques $J_1$ à $J_4$ habituelles d'un capteur de pression et de quatre résistances de compensation $r_1$ à $r_4$. Une résistance de compensation $r_i$ est incluse dans chaque branche du pont, en série avec une des jauges extensométriques $J_i$, mais elle est physiquement disposée près d'une autre jauge extensométrique située dans l'une des deux branches adjacentes. Ainsi, chaque jauge extensométrique partage son environnement thermique avec une résistance de compensation connectée dans une branche voisine du pont de Wheatstone. La tension d'alimentation est appliquée entre les points +A et -A et la tension de sortie est recueillie entre les points +M et -M.

Dans un capteur de pression les valeurs ohmiques, $R_i$, des jauges extensométriques $J_i$ et leurs CTR respectifs $\alpha_i$ sont très proches les uns aux autres, si proches que l'on peut désigner la résistance de chaque jauge à une température de référence par une valeur commune, R, et leur CTR par une valeur commune, $\alpha$. Les résistances de compensation $r_i$ sont choisies pour présenter, à leur tour, une valeur ohmique de résistance commune, r, et un CTR commun, $\beta$.

Dans le cas où le CTR, $\alpha$, des jauges extensométriques n'est pas nul, et les températures respectives des jauges extensométriques s'écartent d'une valeur de référence par des montants $\theta_i$, la tension de sortie $U_S$ de ce circuit est donnée par l'équation (5) suivante:

$$U_S = U_A \frac{A_1 A_2 - A_3 A_4}{(A_1 + A_3)(A_2 + A_4)} \tag{5}$$

avec :

$$A_1 = (R+\Delta R)(1+\alpha\theta_1) + r(1+\beta\theta_3),$$

$$A_2 = (R+\Delta R)(1+\alpha\theta_2) + r(1+\beta\theta_4),$$

$$A_3 = (R-\Delta R)(1+\alpha\theta_3) + r(1+\beta\theta_2),$$

et

$$A_4 = (R-\Delta R)(1+\alpha\theta_4) + r(1+\beta\theta_1).$$

(la tension d'alimentation $U_A$ et la pression étant fixes).

Selon la présente invention la valeur ohmique, r, des résistances de compensation est sélectionnée en respectant la relation (6) suivante:

$$R\alpha = r\beta \qquad (6)$$

Dans ce cas, même si des différences existent entre les températures des jauges constituant le pont de Wheatstone, la tension de sortie ne dépend plus de ces températures différentes. Il est aussi nécessaire de sélectionner $r \leq R/2$ afin de limiter la perte de sensibilité du circuit de pont.

Selon la présente invention, la valeur ohmique, r, des résistances de compensation $r_i$ est, de préférence, sélectionnée la plus faible possible par rapport à la valeur ohmique, R, commune aux jauges extensométriques $J_i$ ($r << R$), et le CTR, $\beta$, des résistances de compensation $r_i$ est sélectionnée nettement supérieur au CTR, $\alpha$, des jauges extensométriques $J_i$ ($\alpha << \beta$).

Dans ces conditions, l'équation (5) se simplifie en l'équation (7) ci-dessous:

$$U_S = U_A \left(\frac{\Delta R}{R}\right)\left(1-\frac{r}{2R}\right) \qquad (7)$$

En comparant les équations (3) et (7) on constate que, dans le cas d'une variation de la pression appliquée, le signal de sortie du pont de Wheatstone comportant les éléments de compensation est inférieur à celui du pont de Wheatstone dépourvu de ces éléments. Ceci correspond à une perte de sensibilité de mesure du circuit égale à r/2R. Si on sélectionne la valeur ohmique de résistance, r, des éléments de compensation égale à ½R cette perte de sensibilité devient 25%, ce qui peut être tolérer au vu de l'immunité aux gradients de température obtenue en contrepartie.

Il est préférable d'employer des résistances de compensation dont la valeur ohmique de résistance est au maximum égale à environ 1/10 R (ce qui demande pour la valeur du CTR des résistances de compensation une valeur $\beta = 10\alpha$). Dans un tel cas, la sensibilité du capteur de pression n'est guère affectée par la présence dans le circuit des résistances de compensation (la tension de sortie perd 5% de sa valeur par rapport au cas où il n'y a pas de résistance de compensation et le comportement du pont est idéal). On pourrait amoindrir la perte de sensibilité en choisissant la valeur ohmique des résistances de compensation encore plus faible par rapport à la valeur ohmique des jauges extensométriques, par exemple en conférant à r une valeur au maximum égale à 5% de R.

Un exemple de la configuration des jauges extensométriques $J_1$ à $J_4$ et des résistances de compensation $r_1$ à $r_4$ sur la membrane m d'un capteur de pression selon la présente invention est représenté sur la figure 4 (une vue en plan). Cette configuration peut être produite par dépôt de couches minces sur la membrane. Dans cet exemple, les jauges extensométriques sont en Nickel-Chrome et présentent chacune une résistance de 1000 $\Omega$ et un CTR de $1 \times 10^{-4}/^\circ$C; les résistances de compensation sont en platine et présentent chacune une résistance de 100 $\Omega$ et un CTR de $1 \times 10^{-3}/^\circ$C.

On peut avantageusement remplacer les résistances de compensation en platine utilisées dans le mode de réalisation montré sur la figure 4 par des résistances de compensation en Nickel dont le coefficient de température de résistance est égal à $4 \times 10^{-3}/^\circ$C. Ceci ramène à 1,25% la perte de sensibilité du capteur.

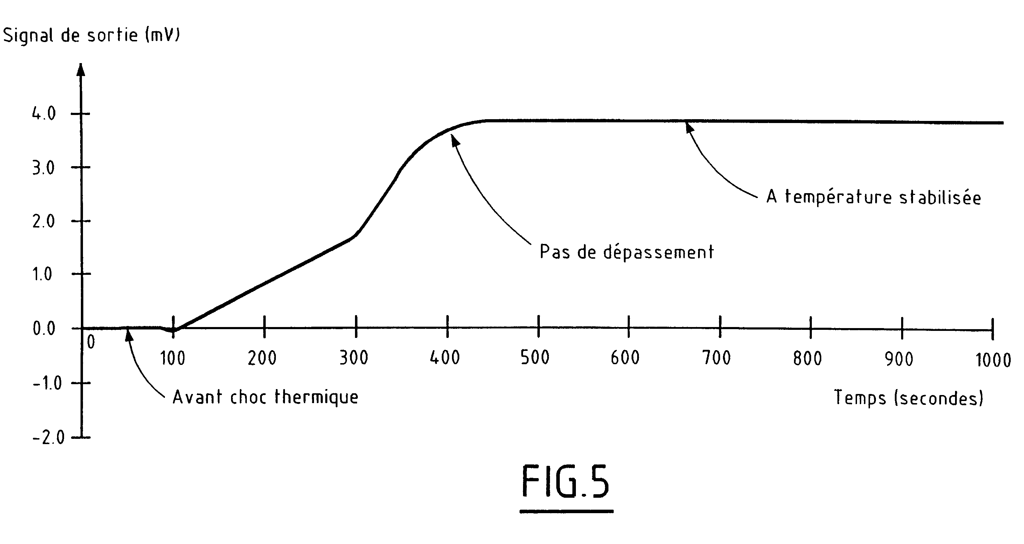

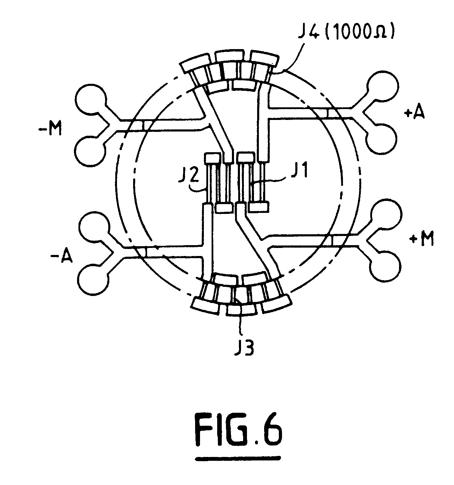

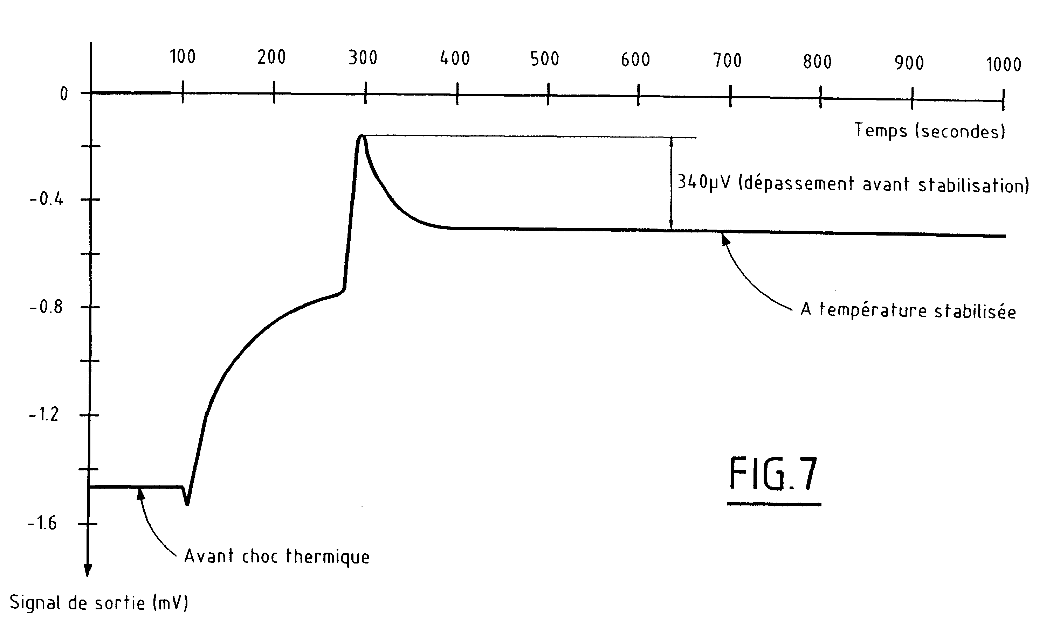

Sur la figure 5 il est représenté le signal de sortie du capteur de la figure 4 dans le cas où celui-ci subit un choc thermique. La figure 6 montre, à titre comparatif, un capteur semblable à celui de la figure 4 mais omettant des résistances de compensation et la figure 7 montre le signal de sortie du capteur de la figure 6 en cas de choc thermique. Une comparaison des figures 5 et 7 montre que, en plus d'être immunisé aux gradients de température existant entre ses résistances principales, le signal de sortie de ce capteur possède aussi une stabilité accrue aux chocs thermiques par rapport aux capteurs de pression classiques.

Bien que le principe de la présente invention ait été décrit dans le contexte des capteurs de pression à jauges extensométriques, il peut également être appliqué, de façon générale, à n'importe quel circuit électrique du type pont de Wheatstone dans lequel les quatre résistances ont sensiblement la même valeur ohmique, R, et sensiblement le même coefficient de température de résistance, $\alpha$.

**Revendications**

1.  Un circuit électrique du type "pont de Wheatstone" comportant quatre éléments de résistance principaux ($J_1$ à $J_4$) ayant chacune sensiblement la même valeur ohmique, R, et sensiblement la même valeur de coefficient de température de résistance, $\alpha$, un élément de résistance principal se trouvant dans chaque branche du pont de Wheatstone, dans lequel chaque branche du pont de Wheatstone comporte un élément de compensation en série avec l'élément de résistance principal correspondant, les éléments de compensation ($r_1$ à $r_4$) présentant chacune sensiblement la même valeur ohmique de résistance, r, et sensiblement le même coefficient de température de résistance, $\beta$, ces valeurs se rapportant à celles des éléments de résistance principaux sensiblement selon la formule:

$$R\alpha = r\beta$$

    et chacun des éléments de résistance principal partage son environnement thermique avec un élément de compensation d'une des branches adjacentes du pont de Wheatstone, **caractérisé en ce que** r < R et, de préférence, $r/R \leq \frac{1}{2}$.

2.  Un circuit électrique selon la revendication 1, **caractérisé en ce que** chaque élément de compensation partage l'environnement thermique d'un élément de résistance principal d'une branche adjacente du pont de Wheatstone en étant disposé physiquement très près de cet élément principal de résistance.

3.  Un circuit électrique selon la revendication 1 ou 2, **caractérisé en ce que** la valeur ohmique de résistance, r, des éléments de compensation est très faible par rapport à celle, R, des éléments de résistance principaux, et le coefficient de température de résistance, $\beta$, des éléments de compensation est nettement supérieur à celui, $\alpha$, des éléments de résistance principaux.

4.  Un circuit électrique selon la revendication 3, **caractérisé en ce que** la valeur ohmique de résistance, r, des éléments de compensation est, au maximum, 10% de la valeur ohmique R des éléments de résistance principaux.

5.  Un circuit électrique selon l'une quelconque des revendications précédentes, **caractérisé en ce qu'**il fait partie d'un capteur de pression à jauges extensométriques, les éléments de résistance principaux étant constitués des jauges extensométriques ($J_1$ à $J_4$) du capteur.

6.  Un circuit électrique selon l'une quelconque des revendications précédentes, **caractérisé en ce que** les éléments de résistance principaux et les éléments de compensation sont en deux métaux différents.

7.  Un circuit électrique selon l'une quelconque des revendications précédentes, **caractérisé en ce que** les éléments de compensation sont en Nickel.

8.  Un capteur de pression à jauges extensométriques comportant quatre jauges extensométriques ($J_1$ à $J_4$) disposées sur une membrane et connectés en pont de Wheatstone, les quatre jauges extensométriques présentant chacune sensiblement la même valeur ohmique, R, et sensiblement le même coefficient de température de résistance, $\alpha$, dans lequel chaque branche du pont de Wheatstone comporte un élément de compensation en série avec la jauge extensométrique correspondante, les éléments de compensation ($r_1$ à $r_4$) présentant chacune sensiblement la même valeur ohmique de résistance, r, et sensiblement le même coefficient de température de résistance, $\beta$, ces valeurs se rapportant à celles des jauges extensométriques sensiblement selon la formule:

$$R\alpha = r\beta$$

et chacune des jauges extensométriques partage son environnement thermique avec un élément de compensation d'une des branches adjacentes du pont de Wheatstone, **caractérisé en ce que** r < R et, de préférence, r/R ≤ ½.

9. Un capteur de pression selon la revendication 8 , **caractérisé en ce que** chaque élément de compensation partage l'environnement thermique d'une jauge extensométrique d'une branche adjacente du pont de Wheatstone en étant disposé physiquement très près de cette jauge.

10. Un capteur de pression selon la revendication 8 ou 9, **caractérisé en ce que** la valeur ohmique de résistance, r, des éléments de compensation est très faible par rapport à celle, R, des jauges extensométriques, et le coefficient de température de résistance, β, des éléments de compensation et nettement supérieur à celui, α, des jauges extensométriques.

11. Un capteur de pression selon la revendication 10 , **caractérisé en ce que** la valeur ohmique de résistance, r, des éléments de compensation est, au maximum, 10% de la valeur ohmique des jauges extensométriques.

12. Un capteur de pression selon l'une quelconque des revendications 8 à 11, **caractérisé en ce que** les éléments de résistance principaux et les éléments de compensation sont en deux métaux différents.

13. Un capteur de pression selon l'une quelconque des revendications 8 à 12, **caractérisé en ce que** les éléments de compensation sont en Nickel.


**Patentansprüche**

1. Elektrische Wheatstone-Brückenschaltung mit vier Hauptwiderstandselementen ($J_1$ bis $_4$), die jeweils im wesentlichen den gleichen Widerstandswert R besitzen und im wesentlichen den gleichen Widerstands-Temperaturkoeffizienten α besitzen, wobei ein Hauptwiderstandselement sich in jedem Zweig der Wheatstone-Brücke befindet, in welcher jeder Zweig der Wheatstone-Brücke ein Kompensationselement aufweist, das mit dem zugehörigen Hauptwiderstandselement in Reihe geschaltet ist, wobei die Kompensationselemente ($r_1$ bis $r_4$) im wesentlichen den gleichen Widerstandswert r besitzen und im wesentlichen den gleichen Widerstands-Temperaturkoeffizienten β aufweisen, wobei diese Werte zu jenen der Hauptwiderstandselemente im wesentlichen gemäß folgender Gleichung in Beziehung stehen:

$$R\alpha = r\beta$$

und jedes der Hauptwiderstandselemente seine thermische Umgebung mit einem Kompensationselement eines der benachbarten Zweige der Wheatstone-Brücke teilt, **dadurch gekennzeichnet daß** r < R und vorzugsweise r/R ≤ 1/2.

2. Elektrische Schaltung nach Anspruch 1, **dadurch gekennzeichnet, daß** jedes Kompensationselement die thermische Umgebung mit einem Hauptwiderstandselement eines benachbarten Zweiges der Wheatstone-Brücke dadurch teilt, daß es baulich in großer Nähe dieses Hauptwiderstandselements angeordnet ist.

3. Elektrische Schaltung nach Anspruch 1 oder 2, **dadurch gekennzeichnet, daß** der Widerstandwert r der Kompensationselemente im Vergleich zu demjenigen R der Hauptwiderstandselemente sehr gering ist und der Widerstands-Temperaturkoeffizient β der Kompensationselemente deutlich größer als derjenige α der Hauptwiderstandselemente ist.

4. Elektrische Schaltung nach Anspruch 3, **dadurch gekennzeichnet, daß** der ohmsche Widerstandswert r der Kompensationselemente maximal 10 % des ohmschen Widerstandswerts R der Hauptwiderstandselemente beträgt.

5. Elektrische Schaltung nach einem der vorhergehenden Ansprüche, **dadurch gekennzeichnet, daß** sie Teil eines Dehnungsmeß-Druckaufnehmers ist, wobei die Hauptwiderstandselemente aus den Dehnungsmeßstreifen ($J_1$ bis $J_4$) des Aufnehmers bestehen.

6. Elektrische Schaltung nach einem der vorhergehenden Ansprüche, **dadurch gekennzeichnet, daß** die Hauptwiderstandselemente und die Kompensationselemente aus zwei verschiedenen Metallen bestehen.

**7.** Elektrische Schaltung nach einem der vorhergehenden Ansprüche, **dadurch gekennzeichnet, daß** die Kompensationselemente aus Nickel bestehen.

**8.** Dehnungsmeß-Druckaufnehmer, umfassend vier Dehnungsmeßstreifen ($J_1$-$J_4$), die auf einer Membran angeordnet sind und als Wheatstone-Brücke verschaltet sind, wobei die vier Dehnungsmeßstreifen jeweils etwa den gleichen ohmschen Wert R haben und im wesentlichen den gleichen Widerstands-Temperaturkoeffizienten $\alpha$ besitzen, wobei in jedem Zweig der Wheatstone-Brücke ein Kompensationselement vorgesehen ist, das mit dem entsprechenden Dehnungsmeßstreifen in Reihe geschaltet ist, wobei die Kompensationselemente ($r_1$-$r_4$) jeweils etwa den gleichen ohmschen Widerstandswert r besitzen und im wesentlichen den gleichen Widerstands-Tempraturkoeffizienten $\beta$ besitzen, wobei diese Werte zu jenen der Dehnungsmeßstreifen etwa gemäß folgender Formel in Beziehung stehen:

$$R\alpha = r\beta,$$

und jeder der Dehnungsmeßstreifen seine thermische Umgebung mit einem Kompensationselement eines der benachbarten Zweige der Wheatstone-Brücke teilt, **dadurch gekennzeichnet, daß** r<R und, vorzugsweise r/R $\leq$ ½.

**9.** Druckaufnehmer nach Anspruch 8, **dadurch gekennzeichnet, daß** jedes Kompensationselement die thermische Umgebung mit einem Dehnungsmeßstreifen eines benachbarten Zweiges der Wheatstone-Brücke dadurch teilt, daß es baulich sehr nahe bei diesem Meßstreifen angeordnet ist.

**10.** Druckaufnehmer nach Anspruch 8 oder 9, **dadurch gekennzeichnet, daß** der ohmsche Widerstandswert r der Kompensationselemente im Vergleich zu jenem, R, der Dehnungsmeßstreifen sehr gering ist, und der Widerstands-Temperaturkoeffizient $\beta$ der Kompensationselemente beträchtlich größer als jener, $\alpha$, der Dehnungsmeßstreifen ist.

**11.** Druckaufnehmer nach Anspruch 10, **dadurch gekennzeichnet, daß** der ohmsche Widerstandswert r der Kompensationselemente maximal 10 % des ohmschen Werts der Dehnungsmeßstreifen beträgt.

**12.** Druckaufnehmer nach einem der Ansprüche 8 bis 11, **dadurch gekennzeichnet, daß** die Hauptwiderstandselemente und die Kompensationselemente aus zwei verschiedenen Metallen bestehen.

**13.** Druckaufnehmer nach einem der Ansprüche 8 bis 12, **dadurch gekennzeichnet, daß** die Kompensationselemente aus Nickel bestehen.

**Claims**

**1.** A "Wheatstone bridge" type electrical circuit comprising four main resistance elements ($J_1$ to $J_4$) each having substantially the same ohmic value, R, and substantially the same value of temperature coefficient of resistance, $\alpha$, a main resistance element being located in each branch of the Wheatstone bridge, wherein each branch of the Wheatstone bridge comprises a compensation element in series with the corresponding main resistance element, the compensation elements ($r_1$ to $r_4$) each having substantially the same ohmic resistance value, r, and substantially the same temperature coefficient of resistance, $\beta$, these values being related to those of the main resistance elements substantially according to the formula:

$$R\alpha = r\beta$$

and each of the main resistance elements shares its thermal environment with a compensation element of one of the adjacent branches of the Wheatstone bridge, **characterised in that** r < R and, preferably, r/R $\leq$ ½.

**2.** An electrical circuit according to claim 1, **characterised in that** each compensation element shares the thermal environment of a main resistance element of an adjacent branch of the Wheatstone bridge by being physically located very close to this main resistance element.

3. An electrical circuit according to claim 1 or 2, **characterised in that** the ohmic value of resistance, r, of the compensation elements is very low in comparison with that, R, of the main resistance elements, and the temperature coefficient of resistance, $\beta$, of the compensation elements is significantly higher than that, $\alpha$, of the main resistance elements.

4. An electrical circuit according to claim 3, **characterised in that** the ohmic value of resistance, r, of the compensation elements is, at the most, 10% of the ohmic value, R, of the main resistance elements.

5. An electrical circuit according to any one of the previous claims, **characterised in that** it forms part of a pressure sensor having strain gauges, the main resistance elements being constituted by the strain gauges ($J_1$ to $J_4$) of the sensor.

6. An electrical circuit according to any one of the previous claims, **characterised in that** the main resistance elements and the compensation elements are made of two different metals.

7. An electrical circuit according to any one of the previous claims, **characterised in that** the compensation elements are made of Nickel.

8. A pressure sensor having strain gauges, comprising four strain gauges ($J_1$ to $J_4$) disposed on a membrane and connected in a Wheatstone bridge configuration, the four strain gauges each having substantially the same ohmic value, R, and substantially the same temperature coefficient of resistance, $\alpha$, wherein each branch of the Wheatstone bridge comprises a compensation element in series with the corresponding strain gauge, the compensation elements ($r_1$ to $r_4$) each having substantially the same ohmic value of resistance, r, and substantially the same temperature coefficient of resistance, $\beta$, these values being related to those of the strain gauges substantially according to formula:

$$R\alpha = r\beta$$

and each of the strain gauges shares its thermal environment with a compensation element of one of the adjacent branches of the Wheatstone bridge, **characterised in that** r < R and, preferably, r/R $\leq$ ½.

9. A pressure sensor according to claim 8, **characterised in that** each compensation element shares the thermal environment of a strain gauge of an adjacent branch of the Wheatstone bridge by being physically disposed very close to this gauge.

10. A pressure sensor according to claim 8 or 9, **characterised in that** the ohmic value of resistance, r, of the compensation elements is very low in comparison with that, R, of the strain gauges, and the temperature coefficient of resistance, $\beta$, of the compensation elements is significantly higher than that, $\alpha$, of the strain gauges.

11. A pressure sensor according to claim 10, **characterised in that** the ohmic value of resistance, r, of the compensation elements is, at the most, 10% of the ohmic value of the strain gauges.

12. A pressure sensor according to any one of claims 8 to 11, **characterised in that** the main resistance elements and the compensation elements are made of two different metals.

13. A pressure sensor according to any one of claims 8 to 12, **characterised in that** the compensation elements are made of Nickel.

FIG.1

FIG.3

FIG.2a

Pression

Tension de sortie = Us

FIG.2b

FIG.4

FIG.5

EP 0 866 958 B1

## FIG.6

100    200    300    400    500    600    700    800    900    1000

0

Temps (secondes)

340µV (dépassement avant stabilisation)

-0.4

A température stabilisée

-0.8

EP 0 866 958 B1

-1.2

FIG.7

-1.6

Avant choc thermique

Signal de sortie (mV)